# EUROPEAN PATENT SPECIFICATION

(11) **EP 3 089 572 B1**
(45) Date of publication and mention of the grant of the patent: **21.02.2018**
(21) Application number: 13900451.9
(22) Date of filing: 23.12.2013
(51) Int. Cl.: H05K 13/04, H05K 13/00, H05K 13/08

(54) **SUBSTRATE WORK DEVICE**
SUBSTRATARBEITSVORRICHTUNG
DISPOSITIF DE TRAVAIL DE SUBSTRAT

(43) Date of publication of application: 02.11.2016
(73) Proprietor: Fuji Machine Mfg. Co., Ltd., Chiryu-shi, Aichi 472-8686 (JP)
(72) Inventor: OYAMA, Shigeto, Chiryu-shi Aichi 472-8686 (JP); IISAKA, Jun, Chiryu-shi Aichi 472-8686 (JP)
(74) Representative: Grünecker Patent- und Rechtsanwälte PartG mbB
(86) International application number: PCT/JP2013/084388
(87) International publication number: WO 2015/097732

(56) References cited:
- JP-A- 2009 152 638
- JP-A- 2009 152 638
- JP-A- 2009 267 038
- JP-A- 2013 034 015
- US-A1- 2011 197 775
- US-A1- 2012 020 765
- US-A1- 2012 311 854

## Description

### Technical Field

The present invention relates to a board work device provided with a pair of board conveyance devices for conveying circuit boards on two paths.

### Background Art

There is a board work device which is provided with a pair of board conveyance devices for conveying circuit boards on two paths, it is possible to perform various works on the circuit boards which are conveyed on each of the paths, and this is convenient. Specifically, as described in the patent citation PTL 1 denoted below, it is possible to execute mounting work of electronic components on a circuit board which is conveyed using one of the pair of board conveyance devices, and to perform preparation work on a circuit board which is transported using the other. The preparation work is work of preparing the necessary setup for the mounting work or the like, such as arrangement changing of back-up pins which support the circuit board, preparation of a suction nozzle corresponding to the electronic components, and preparation of the electronic components. A further example of a board work device is disclosed in PTL 2.

PTL 1: JP-A-2012-129449
PTL 2: US 2012/020765 A1

### Disclosure of Invention

### Technical Problem

According to the board work device described in the patent citation PTL 1 denoted above, it is possible to execute mounting work and to execute preparation work, and this is convenient. However, the board work device described in the patent citation denoted above is provided with two work heads, one of the two work heads executes the mounting work, and the other executes the preparation work. Meanwhile, there is also a board work device which includes one pair of board conveyance devices but includes only one work head. In such a board work device, when executing the preparation work using the work head, since it is not possible to execute the mounting work, the takt time may be reduced. The present invention is made in light of these issues, and an object thereof is to provide a board work device capable of performing mounting work and preparation work without reducing the takt time.

### Solution to Problem

In order to solve the problems described above, a board work device according to claim 1 of the present application includes a pair of board conveyance devices for conveying circuit boards on two paths, a work head which performs work on the circuit boards which are conveyed by each of the pair of board conveyance devices, a moving device which moves the work head to an arbitrary position on a base, and a control device which controls operation of the work head and the moving device, in which the control device includes a board work execution section which executes board work by the work head on the circuit board which is conveyed by one of the pair of board conveyance devices, and a preparation work execution section which executes preparation work in which a necessary setup for executing the board work on the circuit board which is conveyed by the other of the pair of board conveyance devices is prepared using the work head, and in which the preparation work execution section starts the preparation work at a timing at which the board work by the board work execution section is suspended for work relating to the work on the circuit board which is conveyed by one of the pair of board conveyance devices.

In the board work device according to claim 2, in the board work device according to claim 1, the control device includes a board work prioritization control execution section which suspends the preparation work by the preparation work execution section in a case in which a suspension reason of the board work by the board work execution section is solved, and executes board work prioritization control in which the board work by the board work execution section is restarted.

In the board work device according to claim 3, in the board work device according to claim 2, the control device includes a preparation work prioritization control execution section which executes preparation work prioritization control in which the preparation work by the preparation work execution section is continued even in a case in which a suspension reason of the board work by the board work execution section is solved.

In the board work device according to claim 4, in the board work device according to claim 3, the control device executes the preparation work prioritization control by the preparation work prioritization control execution section instead of the board work prioritization control by the board work prioritization control execution section using input of a predetermined signal as a condition when the board work prioritization control is being executed by the board work prioritization control execution section.

In the board work device according to claim 5, in the board work device according to claim 4, the predetermined signal is a notification signal of loading of the circuit board to the other of the pair of board conveyance devices.

### Advantageous Effects of Invention

In the board work device according to claim 1, the preparation work is started at a timing at which the board work is suspended for the work relating to the work on the circuit board which is the target of the board work. During the board work such as the mounting work, the board work of the work head is suspended due to the work relating to the work on the circuit board, that is, the work which is necessary for performing the work on the circuit board, for example, the conveyance work of the circuit board, the replenishing work of the electronic components, the temperature adjustment work of an adhesive or the like, transmission and reception work of data, and the like. Therefore, in the board work device according to claim 1, the preparation work is executed using various waiting times during the board work. Accordingly, it becomes possible to perform the preparation work without reducing the takt time of the board work.

In the board work device according to claim 2, in a case in which the suspension reason of the board work is solved, the board work prioritization control, in which the preparation work is suspended and the board work is resumed, is executed. Accordingly, it becomes possible to appropriately secure the takt time reduction prevention of the board work.

In the board work device according to claim 3, in a case in which the suspension reason of the board work is solved, the preparation work prioritization control, in which the preparation work is continually executed, is executed. Accordingly, it becomes possible to swiftly complete the preparation work.

In the board work device according to claim 4, the preparation work prioritization control is executed instead of the board work prioritization control, using the input of a predetermined signal as a condition when the board work prioritization control is being executed. Accordingly, at ordinary times, the board work is executed with priority, and in a case in which there is an imperative to swiftly complete the preparation work, it becomes possible to execute the preparation work with priority.

In the board work device according to claim 5, the preparation work prioritization control is executed instead of the board work prioritization control in a case in which there is notification of loading of the circuit board into the board conveyance device in which the preparation work is being executed. In a case in which the circuit board is loaded into the board conveyance device in which the preparation work is being executed, it is necessary to execute the work on the circuit board as fast as possible. Therefore, according to the board work device according to claim 5, it becomes possible to swiftly complete the preparation work and to perform the work on the circuit board which is newly loaded.

### Brief Description of Drawings

[Fig. 1] Fig. 1 is a perspective diagram illustrating a board working system which is an example of the present invention.
[Fig. 2] Fig. 2 is a perspective diagram illustrating a mounting device with which the board working system is provided.
[Fig. 3] Fig. 3 is a plan diagram illustrating the mounting device with which the board working system is provided.
[Fig. 4] Fig. 4 is a perspective diagram illustrating a conveyance device with which a mounting machine is provided.
[Fig. 5] Fig. 5 is a block diagram illustrating a control device with which the mounting machine is provided.

### Best Mode for Carrying Out the Invention

Hereinafter, detailed description will be given of the example of the present invention with reference to the drawings as a mode for carrying out the present invention.

### <Configuration of Board Working System>

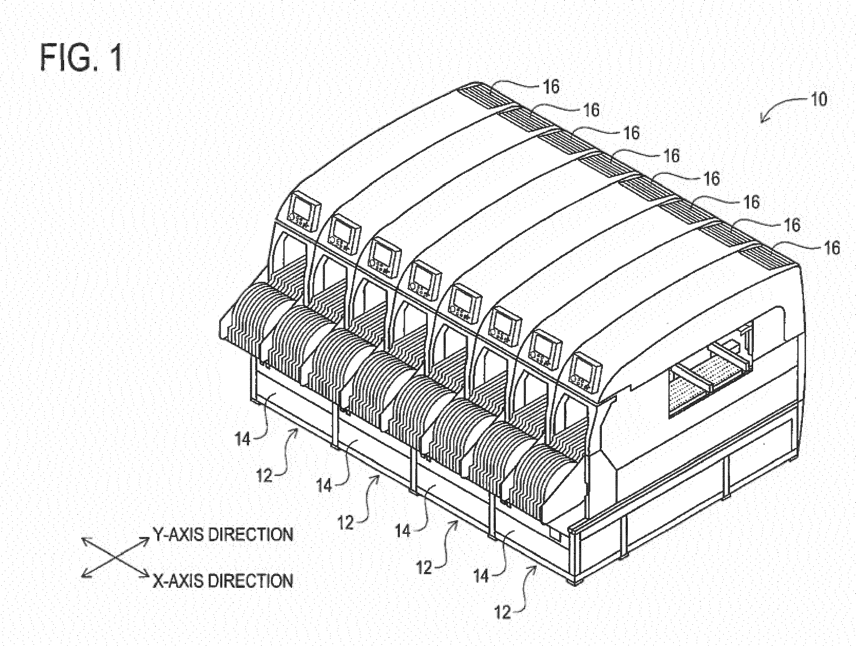

Fig. 1 illustrates a board working system 10. The system 10 depicted in Fig. 1 is a system for mounting electronic components onto circuit boards. The board working system 10 is formed from four electronic component mounting devices 12 (hereinafter, there are cases in which this is shortened to "mounting device"). The four mounting devices 12 are installed in a row in a state of being adjacent to each other. In the following description, the direction in which mounting devices 12 are lined up will be referred to as an X-axis direction, and a horizontal direction which is perpendicular thereto will be referred to as a Y-axis direction.

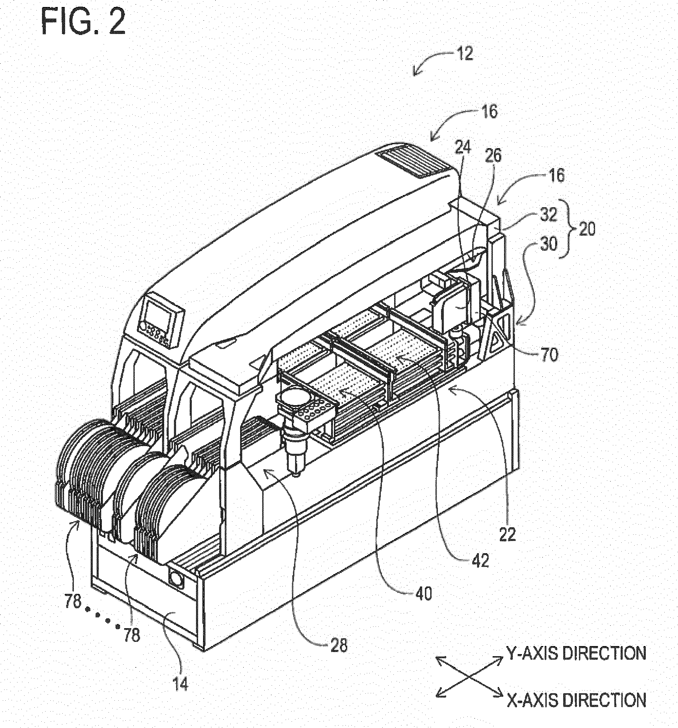

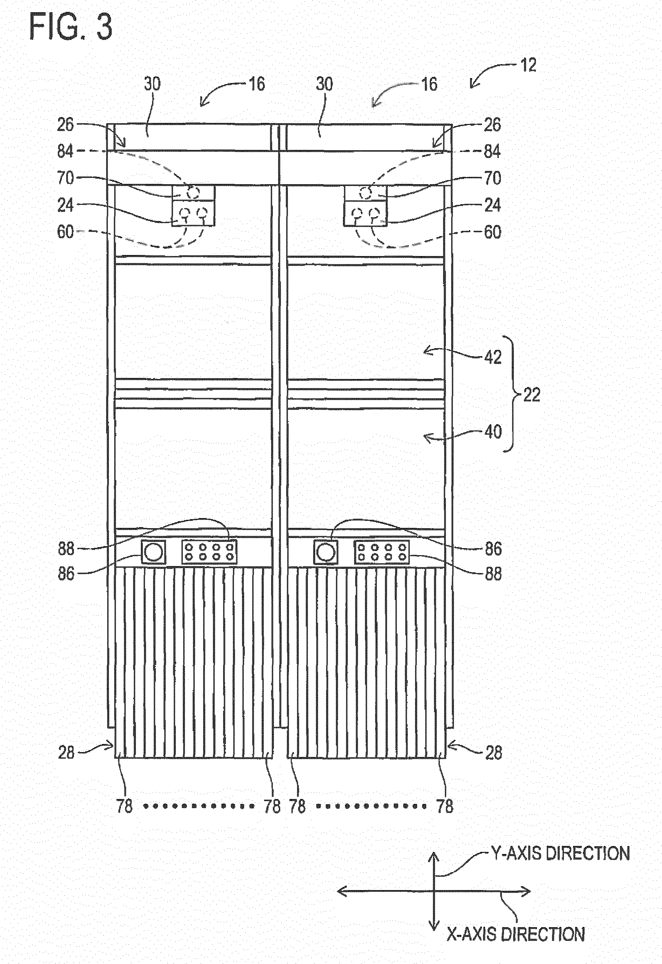

The four mounting devices 12 have substantially the same configuration as each other. Therefore, one of the four mounting devices 12 will be representatively described. As illustrated in Figs. 2 and 3, the mounting device 12 includes one system base 14, and two mounting machines 16 which are adjacent to each other on the system base 14. Each of the mounting machines 16 mainly includes a mounting machine main body 20, a conveyance device 22, a mounting head 24, a mounting head moving device 26 (hereinafter, there are cases in which this is shortened to "moving device"), and a supply device 28. The mounting machine main body 20 is formed of a frame section 30, and a beam section 32 which bridges over the frame section 30.

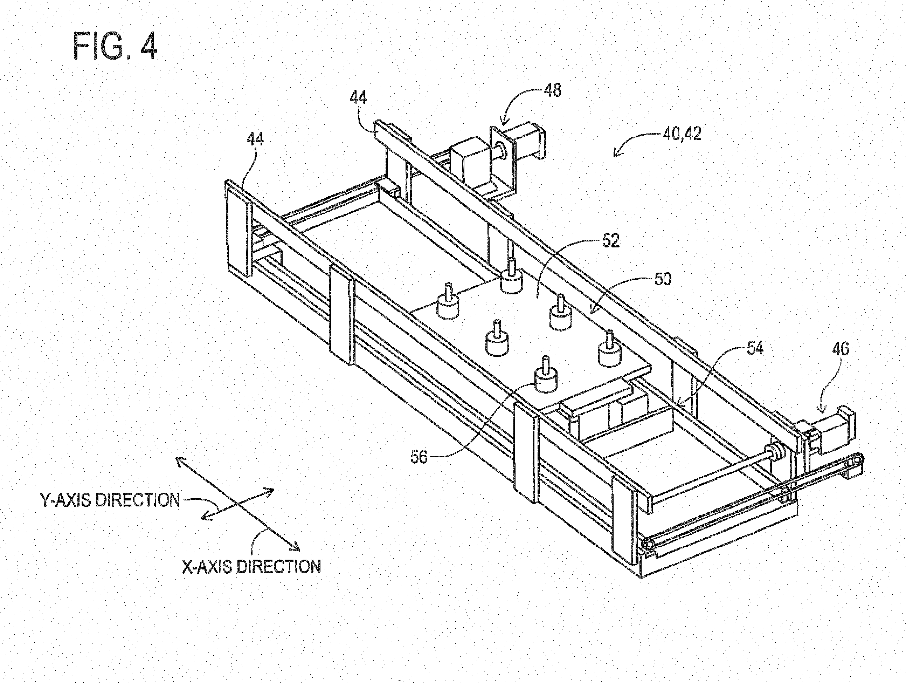

The conveyance device 22 is provided with two conveyance devices 40 and 42. The two conveyance devices 40 and 42 are installed on the frame section 30 to be parallel to each other and to extend in the X-axis direction. As illustrated in Fig. 4, each of the conveyance devices 40 and 42 includes a pair of conveyor belts 44, and the pair of conveyor belts 44 revolve through the driving of an electromagnetic motor 46. Accordingly, the conveyance device 40 or 42 conveys a circuit board which is supported on the conveyor belts 44 in the X-axis direction.

One of the pair of conveyor belts 44 is capable of moving in the Y-axis direction, and moves to an arbitrary position in the Y-axis direction through the driving of the electromagnetic motor 48. In other words, it is possible to change the distance between the pair of conveyor belts 44 in a controllable manner through the driving of the electromagnetic motor 48. Accordingly, the conveyance device 40 or 42 is capable of conveying various sizes of circuit board by changing the distance between the pair of conveyor belts 44 according to the sizes of the circuit board.

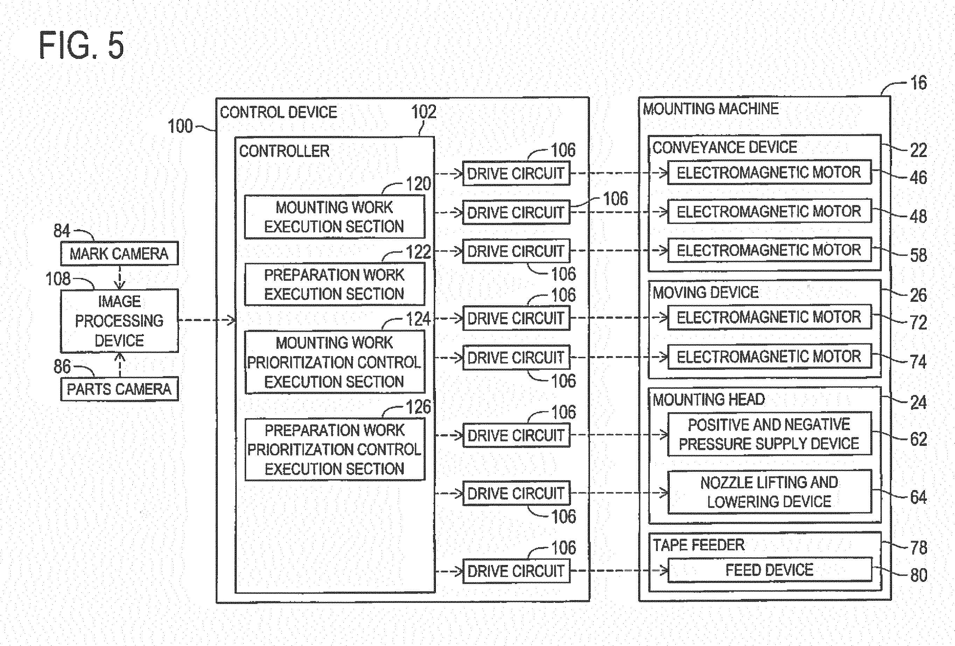

The conveyance device 40 or 42 includes a board holding device 50. The board holding device 50 includes a board support table 52 which is provided between the pair of conveyor belts 44, a lifting and lowering device 54 which lifts and lowers the board support table 52, and a plurality of back-up pins 56 which are provided to stand on the top face of the board support table 52. The board holding device 50 lifts the board support table 52 through the operation of an electromagnetic motor 58 (refer to Fig. 5) which is the drive source of the lifting and lowering device 54. Accordingly, the circuit board which is supported by the conveyor belt 44 is held up by the plurality of back-up pins 56. The circuit board is held in a fixed manner by being pinched by a brim section (not illustrated) which is provided on the conveyor belts 44 and the back-up pins 56. The back-up pins 56 are fixed to the top face of the board support table 52 by magnetic force and are capable of being attached to and detached from the board support table 52. Therefore, the back-up pins 56 are fixed to arbitrary positions of the board support table 52 according to the size, shape, and the like of the circuit board.

The mounting head 24 mounts an electronic component onto the circuit board. As illustrated in Fig. 3, two suction nozzles 60 are provided on the bottom end surface of the mounting head 24 . Each of the suction nozzles 60 communicates with a positive and negative pressure supply device 62 (refer to Fig. 5) via negative pressure air and positive pressure air paths. Each of the suction nozzles 60 vacuums and holds an electronic component using a negative pressure, and releases the held electronic component using a positive pressure. The mounting head 24 includes a nozzle lifting and lowering device 64 (refer to Fig. 5) which lifts and lowers the suction nozzle 60. The mounting head 24 changes the position of the held electronic component in the vertical direction using the nozzle lifting and lowering device 64. The suction nozzle 60 is capable of being attached to and detached from the mounting head 24, and it is possible to exchange according to the size and the like of the electronic component.

The moving device 26 is an XY robot-type moving device. The moving device 26 is provided with an electromagnetic motor 72 (refer to Fig. 5) which causes a slider 70 to slide in the X-axis direction, and an electromagnetic motor 74 (refer to Fig. 5) which causes the slider 70 to slide in the Y-axis direction. The mounting head 24 is attached to the slider 70, and the mounting head 24 moves to an arbitrary position above the frame section 30 due to the operation of the two electromagnetic motors 72 and 74.

The supply device 28 is a feeder-type supply device and is installed on the end portion of the front side of the frame section 30. The supply device 28 includes a tape feeder 78. The tape feeder 78 accommodates taped components in a wound state. The taped components are obtained by taping the electronic components. The tape feeder 78 feeds out the taped components using a feed device 80 (refer to Fig. 5). Accordingly, the feeder-type supply device 28 supplies the electronic components to the supply position by feeding out the taped components. The tape feeder 78 can be attached to and detached from the frame section 30, and it is possible to support the exchanging or the like of the electronic components.

The mounting machine 16 is provided with a mark camera 84, a parts camera 86, and a nozzle changer 88. The mark camera 84 is fixed to the bottom face of the slider 70 in a state of facing downward. Accordingly, the mark camera 84 is capable of imaging an arbitrary position on the frame section 30 due to the slider 70 being moved by the moving device 26. The parts camera 86 is provided between the conveyance device 22 and the supply device 28 in a state of facing upward, and is capable of imaging the electronic component which is held by the mounting head 24.

A plurality of the suction nozzles 60 are stored in the nozzle changer 88, and the nozzle changer 88 is capable of automatically exchanging the suction nozzle 60 which is mounted to the mounting head 24 with the suction nozzles 60 which are stored in the nozzle changer 88. The distance between the two suction nozzles 60 which are mounted to the mounting head 24 is the same as the distance between two of the suction nozzles 60 which are adjacent among the plurality of suction nozzles 60 which are stored in the nozzle changer 88. Accordingly, it becomes possible to exchange two of the suction nozzles 60 at the same time during nozzle exchanging.

Pin grippers (not illustrated) for gripping the back-up pins 56 are also stored in the nozzle changer 88, and the nozzle changer 88 is capable of automatically exchanging the suction nozzles 60 which are mounted in the mounting head 24 with the pin grippers which are stored in the nozzle changer 88.

As illustrated in Fig. 5, the mounting machine 16 is provided with a control device 100. The control device 100 is provided with a controller 102 and a plurality of drive circuits 106. The plurality of drive circuits 106 are connected to the electromagnetic motors 46, 48, 58, 72, and 74, the positive and negative pressure supply device 62, the nozzle lifting and lowering device 64, and the feed device 80. The controller 102 is provided with a CPU, a ROM, a RAM, and the like, the main constituent of the controller 102 is a computer, and the controller 102 is connected to the plurality of drive circuits 106. Accordingly, the operation of the conveyance device 22, the moving device 26, and the like is controlled by the controller 102. The controller 102 is also connected to an image processing device 108. The image processing device 108 processes the image data which is obtained by the mark camera 84 and the parts camera 86, and the controller 102 acquires various information from the image data.

### <Mounting Work by Board Working System>

According to the configuration described above, in the board working system 10, a circuit board is conveyed through the inner portions of the eight mounting machines 16 by the conveyance device 22, and electronic components are mounted onto the circuit board by each of the mounting machines 16.

Specifically, first, the circuit board is loaded into the mounting machine 16 which is disposed most upstream of the eight mounting machines 16. In the mounting machine 16, according to the instructions of the controller 102, the circuit board is conveyed to a working position, and, at this position, is held in a fixed manner by the board holding device 50. Next, the mark camera 84 moves above the circuit board and images the circuit board according to the instructions of the controller 102. Accordingly, the controller 102 acquires information relating to the error of the holding position of the circuit board.

The tape feeder 78 feeds the taped components and supplies the electronic components to the supply position according to the instructions of the controller 102. The mounting head 24 moves above the supply position of the electronic components and vacuum holds the electronic component using the suction nozzle 60 according to the instructions of the controller 102. Subsequently, the mounting head 24 moves above the parts camera 86, and the parts camera 86 images the electronic component which is vacuum held by the suction nozzle 60 according to the instructions of the controller 102. Accordingly, the controller 102 acquires information relating to the error of the suction position of the electronic component.

The mounting head 24 moves above the circuit board, the error of the holding position, the error of the suction position of the held electronic component and the like is corrected, and the electronic component is mounted onto the circuit board according to the instructions of the controller 102. When the mounting work of the electronic components onto the circuit board is completed, the circuit board is conveyed downstream and is loaded into the mounting machine 16 which is disposed on the downstream side. A circuit board onto which electronic components are mounted is produced due to the mounting work described above being sequentially executed by each of the mounting machines 16.

### <Preparation Work in Board Working System>

In order to execute the mounting work described above, it is necessary to prepare the necessary setup for the mounting work. Examples of the preparation work of the necessary setup for the mounting work include adjustment work of the distance (hereinafter, there are cases in which this is shortened to inter-conveyor distance) between the pair of conveyor belts 44, installation work of the back-up pins 56 onto the board support table 52, storage work of the suction nozzles 60 into the nozzle changer 88, and mounting work of the tape feeder 78 to the frame section 30.

The adjustment work of the inter-conveyor distance is work of adjusting the inter-conveyor distance by controlling the operation of the electromagnetic motor 48 according to the size of the circuit board which is the target of the mounting work. Specifically, first, the mark camera 84 images the conveyor belt 44 capable of moving in the Y-axis direction of the pair of conveyor belts 44 according to the instructions of the controller 102. Symbols with which it is possible to recognize the position of the conveyor belt 44 are marked on the conveyor belt 44, and the inter-conveyor distance is computed based on the imaging data of the symbols. The operation of the electromagnetic motor 48 is controlled such that the computed inter-conveyor distance is a distance corresponding to the circuit board which is the target of the mounting work.

The installation work of the back-up pins 56 onto the board support table 52 is work in which the installation positions of the back-up pins 56 on the board support table 52 are changed according to the shape, size, and the like of the circuit board which is the target of the mounting work. Specifically, first, the mounting head 24 moves above the nozzle changer 88 and moves the suction nozzle 60 downward according to the instructions of the controller 102. Subsequently, the mounting head 24 releases the suction nozzle 60 in a predetermined vacant position of the nozzle changer 88 and mounts the pin gripper in place of the suction nozzle 60 according to the instructions of the controller 102.

The mounting head 24 in which the pin gripper is mounted moves above the back-up pin 56 which is installed on the board support table 52 and grips the back-up pin 56 using the pin gripper according to the instructions of the controller 102. The mounting head 24 moves above a predetermined position on the board support table 52 and installs the back-up pin 56 which is gripped in the pin gripper in the predetermined position according to the instructions of the controller 102. Accordingly, the back-up pin 56 is installed in a position corresponding to the shape, size, and the like of the circuit board which is the target of the mounting work.

The storage work of the suction nozzle 60 into the nozzle changer 88 is work in which the suction nozzles 60 which are used in the mounting work are stored in a predetermined arrangement order. Specifically, the mounting head 24 moves above the nozzle changer 88 and moves the suction nozzle 60 downward according to the instructions of the controller 102. Subsequently, the mounting head 24 releases the suction nozzle 60 in a predetermined vacant position of the nozzle changer 88 and mounts the suction nozzle 60 which is stored in the nozzle changer 88 according to the instructions of the controller 102. By repeating the nozzle exchanging in this manner, the suction nozzles 60 which are used in the mounting work are stored in the nozzle changer 88 in a predetermined arrangement order. In particular, in the mounting machine 16, as described above, since it is possible to perform the exchanging work of two of the suction nozzles 60 at the same time, it is important to store the suction nozzles 60 which are used in the mounting work in the nozzle changer 88 in a predetermined arrangement order.

The mounting work of the tape feeder 78 to the frame section 30 is work in which a worker mounts the tape feeder 78 in which the electronic components which are used in the mounting work are stored to the frame section 30. The tape feeders 78 which are not necessary for the mounting work among the tape feeders 78 which are mounted to the frame section 30 are removed from the frame section 30 by the worker.

### <Execution of Preparation Work at Timing at Which Mounting Work is Suspended>

The two conveyance devices 40 and 42 are provided in the mounting machine 16, and it is possible to convey the circuit boards on two paths. Therefore, there is a case in which the mounting work is executed on the circuit board (hereinafter, there are cases in which this is denoted as a first circuit board) which is conveyed by one of the two conveyance devices 40 and 42, for example, the conveyance device 40 (hereinafter, there are cases in which this is denoted as the first conveyance device 40 when distinguishing the first conveyance device 40 from the conveyance device 42), and the preparation work is executed on the circuit board (hereinafter, there are cases in which this is denoted as a second circuit board) which is conveyed by the other of the two conveyance devices 40 and 42, for example, the conveyance device 42 (hereinafter, there are cases in which this is denoted as the second conveyance device 42 when distinguishing the second conveyance device 42 from the first conveyance device 40).

However, since there is only one mounting head 24 in the mounting machine 16, there is a concern that it may not be possible to appropriately perform the mounting work on the first circuit board due to the preparation work on the second circuit board, thereby leading to a reduction in takt time. Specifically, of the preparation work on the second circuit board, when the adjustment work of the inter-conveyor distance, the installation work of the back-up pins 56, and the storage work of the suction nozzle 60 into the nozzle changer 88 are executed, since the mounting head 24 is used, it is not possible to perform the mounting work on the first circuit board and there is a reduction in the takt time of the mounting work on the first circuit board. Of the preparation work on the second circuit board, when the mounting work of the tape feeder 78 to the frame section 30 is executed, since the mounting head 24 is not used, it is possible to perform the mounting work on the first circuit board.

In light of the above, in the mounting machine 16, the preparation work using the mounting head 24 on the second circuit board is performed at a timing at which the mounting work on the first circuit board is suspended for work relating to the work on the first circuit board. Specifically, during the mounting work, the mounting work is suspended in order to execute work relating to the mounting work, that is, to execute work necessary for the mounting work. Examples of work relating to the mounting work include conveyance work of the circuit board, replenishing work of the electronic components, temperature adjustment work of an adhesive or the like when the applying work of the adhesive or the like is performed, and transmission and reception work of data. The preparation work on the second circuit board is started at a timing at which the mounting work on the first circuit board is suspended by the work relating to the mounting work. Therefore, using various waiting times during the mounting work on the first circuit board, the preparation work is executed on the second circuit board. Accordingly, it becomes possible to perform the preparation work on the second circuit board without reducing the takt time of the mounting work on the first circuit board.

However, there is a case in which the preparation work on the second circuit board is not completed during the suspension of the mounting work on the first circuit board. In other words, there is a case in which the preparation work on the second circuit board is not completed when the suspension reason of the mounting work on the first circuit board is solved. In this case, control (hereinafter, there are cases in which this is denoted as mounting work prioritization control) in which the mounting work on the first circuit board is prioritized over the preparation work on the second circuit board is executed. Specifically, in a case in which the preparation work on the second circuit board is not completed when the suspension reason of the mounting work on the first circuit board is solved, the preparation work on the second circuit board is suspended, and the mounting work on the first circuit board is resumed. Accordingly, it becomes possible to execute the mounting work on the first circuit board with priority, and it becomes possible to appropriately secure the takt time reduction prevention.

Meanwhile, there is also a case in which it is desirable to swiftly complete the preparation work on the second circuit board, and in such a case, control (hereinafter, there are cases in which this is denoted as preparation work prioritization control) in which the preparation work on the second circuit board is prioritized over the mounting work on the first circuit board is executed. Specifically, when the mounting work prioritization control is being executed, there is a case in which the circuit board is loaded into the mounting machine 16 by the second conveyance device 42. In this case, if the preparation work on the second circuit board is not completed, the takt time of the mounting work on the second circuit board may be reduced.

Therefore, in a case in which the circuit board is loaded into the mounting machine 16 by the second conveyance device 42 during the execution of the mounting work prioritization control, if the preparation work on the second circuit board is not completed when the suspension reason of the mounting work on the first circuit board is solved, the preparation work on the second circuit board continues to be executed. Accordingly, it becomes possible to also secure the takt time of the mounting work on the second circuit board. It is possible to determine the loading of the circuit board into the mounting machine 16 by the second conveyance device 42 through a signal from the mounting machine 16 of the upstream side. For example, it is possible to provide a sensor at the loading entrance of the circuit board by the second conveyance device 42, and to determine the conveying through a signal from the sensor.

As illustrated in Fig. 5, the controller 102 of the control device 100 includes a mounting work execution section 120 as a functional section for executing the mounting work on the first circuit board. The controller 102 includes a preparation work execution section 122 as a functional section for executing the preparation work on the second circuit board. The controller 102 includes a mounting work prioritization control execution section 124 as a functional section for executing the mounting work prioritization control. The controller 102 includes a preparation work prioritization control execution section 126 as a functional section for executing the preparation work prioritization control.

Incidentally, in the example described above, the mounting machine 16 is an example of the board work device. The mounting head 24 is an example of a work head. The moving device 26 is an example of a moving device. The frame section 30 is an example of a base. The conveyance devices 40 and 42 are examples of a pair of board conveyance devices. The control device 100 is an example of a control device. The mounting work execution section 120 is an example of a board work execution section. The preparation work execution section 122 is an example of a preparation work execution section. The mounting work prioritization control execution section 124 is an example of a board work prioritization control execution section. The preparation work prioritization control execution section 126 is an example of a preparation work prioritization control execution section.

The present invention is not limited to the example described above, and it is possible to carry out the present invention in various modes subjected to various modifications and improvements based on the knowledge of a person skilled in the art. Specifically, for example, in the example, the mounting work prioritization control is switched to the preparation work prioritization control based on a signal notifying the loading of the circuit board; however, it is possible to switch the mounting work prioritization control to the preparation work prioritization control based on various signals. For example, it is possible to adopt various signals such as a signal generated by a button operation of a worker, or a signal generated in accordance with the passage of a predetermined amount of time as the signal which serves to trigger the switching.

In the example described above, examples of work relating to the work on the first circuit board include conveyance work of the circuit board, replenishing work of the electronic components, temperature adjustment work of an adhesive or the like when the application work of the adhesive or the like is performed, and transmission and reception work of data; however, work for handling errors and problems with the mounting work on the first circuit board is also included. In other words, it is possible to perform the preparation work on the second circuit board at a timing at which the mounting work on the first circuit board is being suspended due to errors, problems, and the like in the mounting work.

In the example described above, the technology of the present invention is applied to the mounting machine 16 for executing the mounting work; however, it is possible to apply the technology of the present invention to a device for executing various works on a circuit board. Specifically, for example, it is possible to apply the technology of the present invention to a device for applying cream solder or the like to a circuit board, a device for ejecting an adhesive or the like onto a circuit board, a device for inspecting work results relating to the circuit board, a device for subjecting a circuit board to various processes, or the like.

### Reference Signs List

16: mounting machine (board work device), 24: mounting head (work head), 26: moving device, 30: frame section (base), 40: conveyance device (board conveyance device), 42: conveyance device (board conveyance device), 100: control device, 120: mounting work execution section (board work execution section), 122: preparation work execution section, 124: mounting work prioritization control execution section (board work prioritization control execution section), 126: preparation work prioritization control execution section

## Claims

1. A board work device (16), comprising:
a pair of board conveyance devices (40, 42) for conveying circuit boards on two paths;
a work head (24) which performs work on the circuit boards which are conveyed by each of the pair of board conveyance devices (40, 42);
a moving device (26) which moves the work head (24) to an arbitrary position on a base (30); and
a control device (100) which controls operation of the work head (24) and the moving device (26),
wherein the control device (100) includes
a board work execution section (120) which executes board work by the work head (24) on the circuit board which is conveyed by one of the pair of board conveyance devices (40, 42), and
a preparation work execution section (122) which executes preparation work in which a necessary setup for executing the board work on the circuit board which is conveyed by the other of the pair of board conveyance devices (40, 42) is prepared using the work head (24), **characterized in that**
the preparation work execution section (122) starts the preparation work at a timing at which the board work by the board work execution section (120) is suspended for work relating to the work on the circuit board which is conveyed by one of the pair of board conveyance devices (40, 42).

2. The board work device (16) according to Claim 1,
wherein the control device (100) includes
a board work prioritization control execution section (124) which suspends the preparation work by the preparation work execution section (122) in a case in which a suspension reason of the board work by the board work execution section (120) is solved, and executes board work prioritization control in which the board work by the board work execution section (120) is restarted.

3. The board work device (16) according to Claim 2,
wherein the control device (100) includes
preparation work prioritization control execution section (126) which executes preparation work prioritization control in which the preparation work by the preparation work execution section (122) is continued even in a case in which a suspension reason of the board work by the board work execution section (120) is solved.

4. The board work device (16) according to Claim 3,
wherein the control device (100) executes the preparation work prioritization control by the preparation work prioritization control execution section (126) instead of the board work prioritization control by the board work prioritization control execution section (124) using input of a predetermined signal as a condition when the board work prioritization control is being executed by the board work prioritization control execution section (124).

5. The board work device (16) according to Claim 4,
wherein the predetermined signal is a notification signal of loading of the circuit board to the other of the pair of board conveyance devices (40, 42).

## Patentansprüche

1. Leiterplattenbearbeitungsvorrichtung (16), umfassend:
ein Paar aus Beförderungsvorrichtungen (40, 42) zum Befördern von Leiterplatten auf zwei Wegen;
einen Arbeitskopf (44), der Bearbeitung an den Leiterplatten durchführt, die jeweils von dem Paar von Leiterplattenbeförderungsvorrichtungen (40, 42) befördert werden;
eine Bewegungsvorrichtung (26), die den Arbeitskopf (24) auf eine beliebige Position an einer Basis (30) bewegt; und
eine Steuervorrichtung (100), die den Betrieb des Arbeitskopfes (24) und der Bewegungsvorrichtung (26) steuert,
wobei die Steuervorrichtung (100) beinhaltet
einen Leiterplattenbearbeitungsausführungsabschnitt (120), der Leiterplattenbearbeitung durch den Arbeitskopf (24) an der Leiterplatte durchführt, die von einem aus dem Paar von Leiterplattenbeförderungsvorrichtungen (40, 42) befördert wird;
einen Vorbereitungsbearbeitungsausführungsabschnitt (122), der Vorbereitungsbearbeitung durchführt, in der ein notwendiges Set-up zum Ausführen der Leiterplattenbearbeitung an der Leiterplatte, die von dem anderen Paar von Leiterplattenbeförderungsvorrichtungen (40, 42) befördert wird, unter Verwendung des Arbeitskopfes (24) vorbereitet wird, **dadurch gekennzeichnet, dass**
der Vorbereitungsbearbeitungsausführungsabschnitt (122) die Vorbereitungsbearbeitung an einem Zeitpunkt beginnt, an dem die Leiterplattenbearbeitung durch den Leiterplattenbearbeitungsausführungsabschnitt (120) für Arbeiten bezüglich der Bearbeitung der Leiterplatte ausgesetzt wird, die von einem Paar der Leiterplattenbeförderungsvorrichtungen (40, 42) befördert wird.

2. Leiterplattenbearbeitungsvorrichtung (16) nach Anspruch 1,
wobei die Steuervorrichtung (100) beinhaltet
einen Leiterplattenbearbeitungs-Priorisierungssteuerungsausführungsabschnitt (124), der die Vorbereitungsarbeit durch den Vorbereitungsbearbeitungsausführungsabschnitt (122) in einem Fall aussetzt, in dem ein Aussetzungsgrund für die Leiterplattenbearbeitung durch den Leiterplattenbearbeitungsausführungsabschnitt (120) gelöst ist, und eine Leiterplattenbearbeitungs-Priorisierungssteuerung durchführt, in der die Leiterplattenbearbeitung durch den Leiterplattenbearbeitungsausführungsabschnitt (120) erneut gestartet wird.

3. Leiterplattenbearbeitungsvorrichtung (16) nach Anspruch 2,
wobei die Steuervorrichtung (100) beinhaltet
einen Vorbereitungsbearbeitungs-Priorisierungssteuerungsausführungsabschnitt (126), der die Vorbereitungsbearbeitungs-Priorisierungssteuerung durchführt, in der die Vorbereitungsbearbeitung durch den Vorbereitungsbearbeitungsausführungsabschnitt (122) selbst dann fortgesetzt wird, wenn ein Aussetzungsgrund für die Leiterplattenbearbeitung durch den Leiterplattenbearbeitungsausführungsabschnitt (120) gelöst ist.

4. Leiterplattenbearbeitungsvorrichtung (16) nach Anspruch 3,
wobei die Steuervorrichtung (100) die Vorbereitungsbearbeitungs-Priorisierungssteuerung durch den Vorbereitungsbearbeitungs-Priorisierungssteuerungsausführungsabschnitt (126) anstelle der Leiterplattenbearbeitungs-Priorisierungssteuerung durch den Leiterplattenbearbeitungs-Priorisierungssteuerungsausführungsabschnitt (124) unter Verwendung einer Eingabe eines vorgegebenen Signals als Bedingung ausführt, wenn die Leiterplattenbearbeitungs-Priorisierungssteuerung durch den Leiterplattenbearbeitungs-Priorisierungssteuerungsausführungsabschnitt (124) ausgeführt wird.

5. Leiterplattenbearbeitungsvorrichtung (16) nach Anspruch 4,
wobei das vorgegebene Signal ein Benachrichtigungssignal über die Ladung der Leiterplatte in das andere Paar von Leiterplattenbeförderungsvorrichtungen (40, 42) ist.

## Revendications

1. Dispositif de travail de plaque (16), comprenant :
une paire de dispositifs de convoyage de plaque (40, 42) pour convoyer des circuits imprimés sur deux voies ;
une tête de travail (24) effectuant un travail sur les circuits imprimés qui sont convoyés par chaque dispositif de la paire de dispositifs de convoyage de plaque (40, 42) ;
un dispositif de déplacement (26) qui déplace la tête de travail (24) dans une position arbitraire sur une base (30) ; et
un dispositif de commande (100) qui contrôle le fonctionnement de la tête de travail (24) et du dispositif de déplacement (26),
dans lequel le dispositif de commande (100) inclut
une section d'exécution de travail de plaque (120) qui exécute un travail de plaque par la tête de travail (24) sur le circuit imprimé qui est convoyé par un dispositif de la paire de dispositifs de convoyage de plaque (40, 42), et
une section d'exécution de travail de préparation (122) qui exécute un travail de préparation dans lequel une configuration nécessaire pour exécuter le travail de plaque sur le circuit imprimé qui est convoyé par l'autre dispositif de la paire de dispositifs de convoyage de plaque (40, 42) est préparée à l'aide de la tête de travail (24), **caractérisé en ce que**
la section d'exécution de travail de préparation (122) commence le travail de préparation à un moment où le travail de plaque par la section d'exécution de travail de plaque (120) est suspendu pour un travail relatif au travail sur le circuit imprimé qui est convoyé par un dispositif de la paire de dispositifs de convoyage de plaque (40, 42).

2. Dispositif de travail de plaque (16) selon la revendication 1,
dans lequel le dispositif de commande (100) inclut
une section d'exécution de contrôle de priorisation de travail de plaque (124) qui suspend le travail de préparation par la section d'exécution de travail de préparation (122) dans le cas où une raison de suspension du travail de plaque par la section d'exécution de travail de plaque (120) est résolue, et exécute un contrôle de priorisation de travail de plaque dans lequel le travail de plaque par la section d'exécution de travail de plaque (120) est redémarré.

3. Dispositif de travail de plaque (16) selon la revendication 2,
dans lequel le dispositif de commande (100) inclut
une section d'exécution de contrôle de priorisation de travail de préparation (126) qui exécute un contrôle de priorisation de travail de préparation dans lequel le travail de préparation par la section d'exécution de travail de préparation (122) est poursuivi même dans le cas où une raison de suspension du travail de plaque par la section d'exécution de travail de plaque (120) est résolue.

4. Dispositif de travail de plaque (16) selon la revendication 3,
dans lequel le dispositif de commande (100) exécute le contrôle de priorisation de travail de préparation par la section d'exécution de contrôle de priorisation de travail de préparation (126) au lieu que le contrôle de priorisation de travail de plaque par la section d'exécution de contrôle de priorisation de travail de plaque (124) n'utilise l'entrée d'un signal prédéterminé comme condition quand le contrôle de priorisation de travail de plaque est exécuté par la section d'exécution de contrôle de priorisation de travail de plaque (124).

5. Dispositif de travail de plaque (16) selon la revendication 4,
dans lequel le signal prédéterminé est un signal de notification de charge du circuit imprimé à l'autre dispositif de ladite paire de dispositifs de convoyage de plaque (40, 42) .
